(19) Europäisches Patentamt
European Patent Office
Office européen des brevets

(11)     EP 3 167 516 B1

(12)                                   **EUROPÄISCHE PATENTSCHRIFT**

(45) Veröffentlichungstag und Bekanntmachung des Hinweises auf die Patenterteilung:
19.02.2020  Patentblatt 2020/08

(21) Anmeldenummer: 15737952.0

(22) Anmeldetag: 23.06.2015

(51) Int Cl.:
*H01S 3/06* (2006.01)        *H01S 3/08* (2006.01)
*H01S 3/10* (2006.01)        *H01S 3/113* (2006.01)
*H01S 3/16* (2006.01)        *H01S 3/04* (2006.01)
*H01S 3/042* (2006.01)

(86) Internationale Anmeldenummer:
PCT/AT2015/000090

(87) Internationale Veröffentlichungsnummer:
WO 2016/004446 (14.01.2016 Gazette 2016/02)

(54) **MICROCHIP-LASER**

MICROCHIP LASER

LASER À MICROPUCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.07.2014  AT 5432014**

(43) Veröffentlichungstag der Anmeldung:
**17.05.2017  Patentblatt 2017/20**

(73) Patentinhaber: **Kopf, Daniel**
**6832 Röthis (AT)**

(72) Erfinder: **Kopf, Daniel**
**6832 Röthis (AT)**

(74) Vertreter: **Hofmann, Ralf U. et al**
**Hofmann & Fechner**
**Patentanwälte**
**Hörnlingerstrasse 3**
**Postfach 5**
**6830 Rankweil (AT)**

(56) Entgegenhaltungen:
DE-A1-102012 005 492

• BERNARD BENJAMIN ET AL: "26ps pulses from a passively Q-switched microchip laser", PROCEEDINGS OF SPIE, S P I E - INTERNATIONAL SOCIETY FOR OPTICAL ENGINEERING, US, Bd. 8960, 4. März 2014 (2014-03-04), Seiten 89601D-89601D, XP060034171, ISSN: 0277-786X, DOI: 10.1117/12.2037690 ISBN: 978-1-62841-799-9
• BRAUN B: "56-PS PASSIVELY +-SWITCHED DIODE-PUMPED MICROCHIP LASER", OPTICS LETTERS, OPTICAL SOCIETY OF AMERICA, US, Bd. 22, Nr. 6, 15. März 1997 (1997-03-15), Seiten 381-383, XP000690332, ISSN: 0146-9592

**Beschreibung**

Die Erfindung bezieht sich auf einen Microchip-Laser mit einem monolithischen Resonator, der einen doppelbrechenden Laserkristall aufweist, wobei ein aus dem Resonator ausgekoppelter Laserstrahl, der eine Laserwellenlänge aufweist, entlang einer Laserstrahlachse aus dem Resonator austritt und die auf die Richtung der Laserstrahlachse bezogene Länge des Resonators <=50 μm μm ist.

Microchip-Laser sind Festkörperlaser mit einem monolithischen Resonator und zeichnen sich durch einen besonders kleinen Aufbau aus. Endspiegel des Resonators werden durch Beschichtung des aktiven Lasermediums gebildet und/oder ein einen Endspiegel aufweisendes oder bildendes optisches Element, beispielsweise ein SESAM, wird stoffschlüssig mit dem aktiven Lasermedium verbunden. Solche Verbindungstechniken sind als "bonding" bekannt.

Aufgrund der kurzen Resonatorlängen können mit Microchip-Lasern in einfacher Weise kurze Pulse gebildet werden. So können mittels Güteschaltung ("Q-switching") Pulse mit Pulslängen von weniger als einer Nanosekunde oder auch weniger als 100 Pikosekunden, im Extremfall weniger als 20 Pikosekunden, erreicht werden. Solche Pulse sind beispielsweise für die Mikromaterialbearbeitung von Interesse.

Bestehende modengekoppelte Laser, mit welchen so kurze Pulse erzeugt werden können, sind wesentlich größer ausgebildet. Typische Resonatorlängen sind mehr als 1m und solche Resonatoren können durch mehrfache Faltung in einem Würfel mit einer Kantenlänge von mehr als 10cm untergebracht werden. Ein Resonator eines Microchip-Lasers lässt sich dagegen in einem Würfel mit einer Kantenlänge von weniger als 1mm unterbringen.

Auch eine Verstärkungsschaltung (="gain-switching") kann für einen Microchip-Laser durchgeführt werden, wobei Pulse mit Pulsdauern im Nanosekundenbereich oder auch darunter erzeugt werden können. Grundsätzlich kann ein Microchip-Laser auch kontinuierlich (=im cw-Modus) betrieben werden.

Microchip-Laser besitzen eine potentiell kostengünstige Produktion, weil ein flächenhafter Laseraufbau in einem Batch-Prozess (Wafer-Prozess) hergestellt werden kann, sodass aus einer Fläche von 10mm x 10mm durchaus mehr als 100 Laserresonatoren gewonnen werden können.

Durch den monolithischen Aufbau wird eine besondere Stabilität eines Microchip-Lasers ermöglicht.

Microchip-Laser der eingangs genannten Art mit besonders kurzen Pulsdauern gehen aus der WO 2011/147799 A1, aus Mehner E. et. al. "Sub-20-ps pulses from a passively Q-switched microchip laser at 1 MHz repetition rate", OPTICS LETTERS, Vol. 39, NO. 10/May 15, 2014, 2940-2943 und aus Bernard B. et al., "26 ps pulses from a passively Q-switched microchip laser", Proc of SPIE Vol. 8960, 4. März 2014, Seiten 89601D-1 bis 89601D-7 hervor. In diesen Veröffentlichungen sind weitere Schriften genannt, in denen Microchip-Laser offenbart sind, bei denen mit einer Güteschaltung Pulse mit Pulslängen unter 100 ps erreicht werden.

Aus der DE 10 2012 005 492 A1 geht ein ähnlicher Microchip-Laser mit einer Resonatorlänge von 100 μm hervor.

Bei kurzen Resonatorlängen und geringen Verstärkungsbandbreiten des aktiven Lasermaterials emittieren Microchip-Laser üblicherweise bei einer einzigen Frequenz, d.h. der aus dem Resonator ausgekoppelte Laserstrahl besitzt eine definierte Laserwellenlänge. Die kurze Resonatorlänge führt zu einem großen "free spectral ränge", also einem großen Abstand benachbarter Wellenlängen, die im Resonator resonant sind.

Für Microchip-Laser wird als aktives Lasermedium häufig ein von einem Vanadat gebildeter Laserkristall eingesetzt, insbesondere Nd3+:YVO4 . Nd3+:YVO4 weist als Lasermaterial vorteilhafte Eigenschaften, wie eine vergleichsweise hohe Kleinsignalverstärkung und gute Absorption der Pumpstrahlung auf. Bei Nd3+:YVO4 handelt es sich um einen doppelbrechenden Kristall, wobei die bisherige Erfahrung gezeigt hat, dass ein Microchip-Laser mit Nd3+:YVO4 als Laserkristall mit einer Polarisation entsprechend dem ordentlichen Strahl oder entsprechend dem außerordentlichen Strahl lasern kann.

Doppelbrechende Kristalle sind optisch anisotrop, bei optisch einachsigen doppelbrechenden Kristallen mit Ausnahme für einen Lichteinfall in Richtung der kristalloptischen Achse. Bei optisch einachsigen doppelbrechenden Kristallen ist bei einem Einfall parallel zur einzigen kristalloptischen Achse der Brechungsindex unabhängig von der Polarisationsrichtung des Lichts. Für einen Lichteinfall winkelig zur kristalloptischen Achse wird der Lichtstrahl in zwei linear polarisierte Teilstrahlen aufgeteilt, deren Polarisationsrichtungen rechtwinkelig zueinander sind und die als ordentlicher Strahl und außerordentlicher Strahl bezeichnet werden. Die Brechungsindices sind für den ordentlichen Strahl und außerordentlichen Strahl unterschiedlich, wobei bei einer Lichteinfallsrichtung rechtwinkelig zur kristalloptischen Achse die Differenz der Brechungsindices ihren maximalen Wert annimmt. Bei einem solchen Lichteinfall rechtwinkelig zur kristalloptischen Achse und auf eine rechtwinkelig zur Lichteinfallsrichtung stehenden Eintrittsfläche des doppelbrechenden Kristalls kommt es hierbei zu keiner räumlichen Trennung der rechtwinkelig zueinander polarisierten ordentlichen und außerordentlichen Strahlen.

Ein doppelbrechender Kristall kann auch mehr als eine kristalloptische Achse aufweisen.

Aufgabe der Erfindung ist es einen vorteilhaften Microchip-Laser der eingangs genannten Art bereitzustellen, der eine hohe Stabilität der Polarisationsrichtung des aus dem Resonator ausgekoppelten Laserstrahls aufweist. Erfindungsgemäß gelingt dies durch einen Microchip-Laser mit den Merkmalen des Anspruchs 1.

Beim Microchip-Laser gemäß der Erfindung weist der Laserkristall eine derartige Dicke in Richtung der Laserstrahlachse auf, dass bei einem in Richtung der Laserstrahlachse erfolgenden Einfall eines die Laserwellenlänge aufweisenden Lichtstrahls auf den Laserkristall zwischen dem ordentlichen und dem außerordentlichen Strahl, in welche der Lichtstrahl im Laserkristall aufgeteilt wird, bei einem einzelnen Durchgang durch den Laserkristall eine Phasenverschiebung im Bereich von $\pi/2$ +/- $\pi/4$, vorzugsweise $\pi/2$ +/- $\pi/8$, auftritt. Der doppelbrechende Laserkristall verhält sich also bezüglich dem ordentlichen und dem außerordentlichen Strahl wie ein Lambda/4-Plättchen, wobei eine Abweichung hiervon im zuvor genannten Bereich möglich ist.

Durch die erfindungsgemäße Ausbildung wird eine Polarisationsselektion des ausgekoppelten Laserstrahls mit einer hohen Toleranz gegenüber äußeren Einflüssen, wie der Temperatur, aber auch gegenüber Herstellungsabweichungen, z.B. hinsichtlich der ausgebildeten Länge des Resonators, erreicht.

Die Länge des Resonators in Richtung der Laserstrahlachse beträgt 50 μm oder weniger. Durch einen derartig kurzen Resonator kommt es zu einem großen "free spectral range", also einem großen Abstand zwischen den Wellenlängen, die im Resonator resonant sind, was für eine stabile Unterdrückung der unerwünschten Polarisationsrichtung wichtig ist. Außerdem können bei einem derart kurzen Resonator in einfacher Weise kurze Pulslängen erreicht werden, vorteilhafterweise mittels einer passiven Güteschaltung, wobei als ein Endspiegel insbesondere ein SESAM verwendet werden kann.

Ein erfindungsgemäßer Laser kann grundsätzlich als Dauerstrichlaser betrieben werden. Für viele Anwendungen ist aber eine Ausbildung als Pulslaser vorteilhaft. Die gewünschte Pulsdauer hängt vom Anwendungsfall ab. Es bestehen Anwendungsfälle, in denen Pulslängen im ns-Bereich oder auch im Bereich 100 ps - 1 ns vorteilhaft sind. Solche Pulsdauern können beispielsweise durch eine Verstärkungsschaltung der optischen Pumpanordnung (=gain-switching") erreicht werden.

In vorteilhaften Ausbildungsformen kann die Pulsdauer der Pulse weniger als 100 ps, vorzugsweise weniger als 50 ps betragen, wobei Pulsdauern von weniger als 20 ps denkbar und möglich sind. Die Pulsenergie kann hierbei mehr als 10 nJ oder auch mehr als 30 nJ betragen. Insbesondere können solche kurze Pulsdauern durch die bereits genannte passive Güteschaltung erreicht werden.

Wenn in der vorliegenden Schrift von Pulsdauern die Rede ist, so sind diese auf die Halbwertsbreite der Intensität bezogen (FWHM).

In einer vorteilhaften Ausführungsform der Erfindung ist der Laserkristall Nd3+:YVO4.
Anstelle von YVO4 kommen zur Ausbildung des Laserkristalls auch andere Vanadate in Betracht, z.B. Nd3+:GdVO4 oder Nd3+:GdYV04. Anstelle von Vanadaten können auch andere doppelbrechende Kristalle mit entsprechender Dotierung, z.B. Nd, welche laseraktive Eigenschaften besitzen, z.B. LSB, als Laserkristall eingesetzt werden.

Das den Resonator bildende Schichtsystem wird so ausgebildet, dass eine Resonanz für die gewünschte Polarisation beim Maximum der Verstärkung des Laserkristalls liegt oder hiervon eine nur geringe Abweichung aufweist, vorzugsweise von weniger als 0,5 nm. Die Wellenlänge des ausgekoppelten Laserstrahls, für welche der Lasermode im Laserkristall beim Maximum der Verstärkung des Laserkristalls liegt, wird in dieser Schrift als "Verstärkungswellenlänge" bezeichnet. Für Nd3+:YVO4 liegt diese bei ca. 1064 nm. Die Bandbreite, innerhalb welcher eine ausreichende Verstärkung vorliegt, um einen Lasermode zu erzeugen, liegt ca. 1 nm um diesen Wert.

Vorteilhafterweise stimmt die Laserstrahlachse, entlang von der der Laserstrahl aus dem Resonator austritt, mit der Achse des Laserstrahls innerhalb des Resonators überein und die Laserstrahlachse steht rechtwinkelig zu einer kristalloptischen Achse des Laserkristalls, wobei der Laserkristall vorzugsweise nur eine kristalloptische Achse aufweist (= optisch einachsig ist) und damit bezogen auf einen Einfall parallel zur einzelnen kristalloptischen Achse optisch isotrop ist. Die Differenz der Brechungsindices für Strahlen mit rechtwinkelig zueinander stehenden Polarisationen, entsprechend dem ordentlichen und außerordentlichen Strahl, besitzt in einer solchen Konfiguration, bei der die Achse des Laserstrahls rechtwinkelig zur kristalloptischen Achse steht, ein Maximum. Hierbei wird ein parallel zur Laserstrahlachse in den Laserkristall eintretender Lichtstrahl nicht in einen ordentlichen und außerordentlichen Strahl räumlich getrennt, d.h. der ordentliche und außerordentliche Strahl fallen zusammen, weisen aber rechtwinkelig zueinander stehende Polarisationsrichtungen auf.

Insbesondere sind den Resonator beidseitig begrenzende Endspiegel, zumindest wenn keine Pumpstrahlung in den Laserkristall einfällt, eben und stehen rechtwinkelig zur Laserstrahlachse. Hierbei sind auch die Endflächen des Laserkristalls, durch welche der Laserstrahl mit den Endspiegeln zusammenwirkt, zumindest wenn keine Pumpstrahlung auf den Laserkristall einfällt, eben und stehen rechtwinkelig zur Laserstrahlachse.

Die Laserwellenlänge des ausgekoppelten Laserstrahls weist vorteilhafterweise eine sehr schmale Frequenzverteilung auf, vorzugsweise mit einer Halbwertsbreite der Intensität (FWHM) von weniger als 1 nm, besonders bevorzugt weniger als 0,3 nm. Die Effekte der Frequenzverteilung bezüglich der Intensitätsunterdrückung der unerwünschten Polarisationsrichtung können damit vernachlässigt werden. Wenn in dieser Schrift von der Laserwellenlänge die Rede ist, so bezieht sich diese streng genommen auf das Maximum der Frequenzverteilung des ausgekoppelten Laserstrahls.

Weitere Vorteile und Einzelheiten der Erfindung werden im Folgenden anhand der beiliegenden Zeichnung erläutert. In dieser zeigen:

Fig. 1 eine schematische Darstellung eines Microchip-Lasers gemäß einem ersten Ausführungsbeispiel der Erfindung;

Fig. 2 eine Ansicht des Resonators in Richtung der Laserstrahlachse;

Fig. 3 eine schematische Darstellung der E-Felder für einen Fall, wenn der Resonator bei einer Laserwellenlänge entsprechend der Verstärkungswellenlänge des Laserkristalls für senkrecht zueinander linear polarisierte Laserstrahlen resonant wäre, als Vergleichsbeispiel;

Fig. 4 eine schematische Darstellung der E-Felder des ordentlichen und außerordentlichen Strahls für einen in Richtung der Laserstrahlachse auf den Laserkristall einfallenden Lichtstrahl mit der Laserwellenlänge;

Fig. 5a und 5b schematische Darstellungen des ordentlichen und außerordentlichen Strahls bei einem in Richtung der Laserstrahlachse auf den Laserkristall einfallenden Lichtstrahl;

Fig. 6 eine Tabelle zur Erläuterung einer Simulationsberechnung für ein einen Resonator simulierendes Schichtsystem;

Fig. 7 und 8 Diagramme für die Resonanzlinien des Resonators für Polarisationen entsprechend dem ordentlichen und außerordentlichen Strahl, bei einer erfindungsgemäßen Dicke des Laserkristalls;

Fig. 9 und 10 Diagramme entsprechend Fig. 7 und 8 für eine nicht erfindungsgemäße Dicke des Laserkristalls, als Vergleichsbeispiel;

Fig. 11 eine schematische Darstellung eines erfindungsgemäßen Microchip-Lasers entsprechend einer weiteren möglichen Ausführungsform.

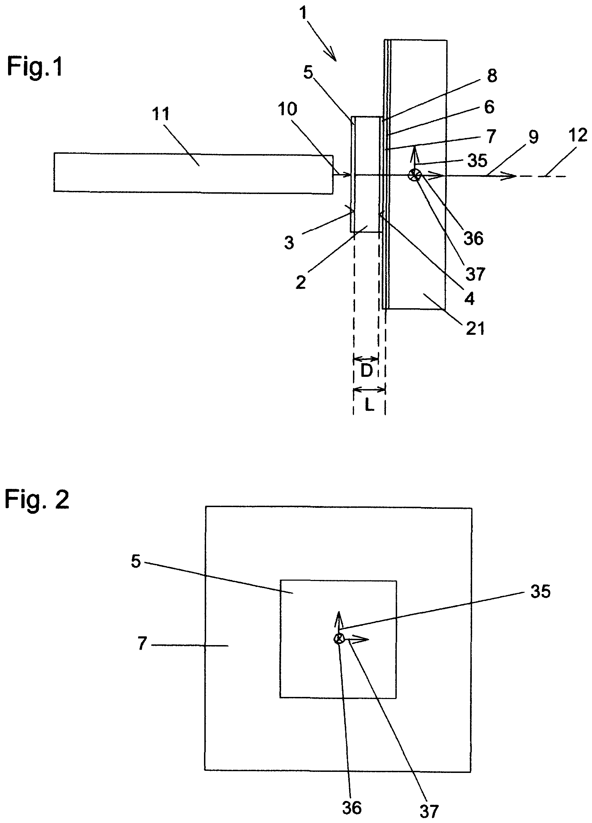

Ein mögliches Ausführungsbeispiel für einen Microchip-Laser gemäß der Erfindung ist schematisch in Fig. 1 und 2 dargestellt. Der Microchip-Laser besitzt einen Resonator 1, der in Form eines monolithischen Blocks ausgebildet ist. Das laseraktive Medium des Resonators 1 ist der Laserkristall 2. Der Laserkristall 2 besitzt gegenüberliegende Endflächen 3, 4. Durch diese gegenüberliegenden Endflächen hindurch wirkt ein im Betrieb des Lasers im Laserkristall 2 sich ausbildender Laserstrahl (=Lasermode) mit Endspiegeln 5, 6 des Resonators 1 zusammen. Der erste Endspiegel 5 wird hier von einer optischen Beschichtung der Endfläche 3 des Laserkristalls 2 gebildet. Der zweite Endspiegel 6 ist im Ausführungsbeispiel in Form eines Bragg-Spiegels ausgebildet und Teil eines SESAM, welcher außerdem eine Absorberschicht 7 aufweist, die einen sättigbaren Absorber bildet. Zwischen der Absorberschicht 7 des SESAM und dem Laserkristall 2 befindet sich noch eine Reflexionsschicht 8 für die Pumpstrahlung, welche für den Laserstrahl zumindest teildurchlässig ist, z. B. 30%.

Die Reflexionsschicht 8 ist als optische Beschichtung auf den Resonator 1 aufgebracht. Der die Absorberschicht 7 und zweiten Endspiegel 6 umfassende SESAM ist in diesem Ausführungsbeispiel auf einem Trägersubstrat 21 in Form von GaAs (z.B. 0,4mm dick) ausgebildet. Die Einheit umfassend den SESAM und das Trägersubstrat 21 wird durch Bonding, also stoffschlüssig, mit dem mit der Reflexionsschicht 8 beschichteten Resonator 1 verbunden.

Der zweite Endspiegel 6 ist teilreflektierend ausgebildet, um den Laserstrahl 9 auszukoppeln.

Das Trägersubstrat 21 selbst stellt keinen Teil des Resonators 1 dar. Auf der vom Laserkristall 2 abgewandten Seite des Trägersubstrats 21 ist günstigerweise eine Antireflexionsschicht für den Laserstrahl aufgebracht.

Eine Ausbildung mit einem Trägersubstrat 21 könnte in anderen Ausführungsbeispielen auch entfallen.

Der erste Endspiegel 5 dient im Ausführungsbeispiel zur Einkopplung der Pumpstrahlung und ist hierzu für die Pumpstrahlung 10 möglichst transmittierend ausgebildet, während er für Licht mit der optischen Frequenz der Laserstrahlung hochreflektierend ist.

Zur Emission der Pumpstrahlung wird eine Laserdiode oder ein Laserdioden-Array eingesetzt, wobei die Pumpstrahlung im schematisch dargestellten Ausführungsbeispiel durch einen Lichtleiter 11, von dem in Fig. 1 schematisch ein Ende dargestellt ist, dem Resonator zugeführt wird. Auch eine Anordnung der Laserdiode oder des Laserdioden-Arrays direkt vor dem Resonator 1 ist denkbar und möglich. Zusätzliche Linsen zum Fokussieren der Pumpstrahlung können vorgesehen sein, sind in der schematischen Fig. 1 aber nicht dargestellt.

Vorteilhafterweise beträgt der Durchmesser der Pumpstrahlung im Laserkristall weniger als 100 $\mu$m, vorzugsweise weniger als 50 $\mu$m, besonders bevorzugt weniger als 30 $\mu$m, bezogen auf die Halbwertsbreite der Intensität (also FWHM). Der Durchmesser des Pumpstrahls kann hierbei auch an die Dicke D des Laserkristalls 2 angepasst werden, wobei ein Pumpvolumen mit weitgehend gleichem Durchmesser und gleicher Länge erreicht werden kann.

Der monolithisch ausgebildete Resonator 1 kann weitere und/oder andere optische Elemente aufweisen.

"Monolithisch" bedeutet hierbei, dass die den Resonator bildenden Elemente stoffschlüssig miteinander verbunden sind, insbesondere mittels eines herkömmlichen Bondings. Bonding ist beispielsweise in Form von Diffusion-Bonding, Ansprengen oder Adhäsiv-Bonding (mittels einer Klebstoffschicht) bekannt.

Beim Resonator 1 handelt es sich um einen Stehende-Wellen-Resonator. Zumindest solange keine Pumpstrahlung in den Laserkristall 2 einfällt, sind im gezeigten Microchip-Laser die Endflächen 3, 4 des Laserkristalls 2 eben und liegen parallel zueinander. Ebenso sind die Endspiegel 5 und 6 eben und liegen parallel zueinander. Im Betrieb des Lasers, wenn die Pumpstrahlung 10 in den Laserkristall 2 einfällt, kommt es zur Ausbildung einer thermischen Linse, inklusive einer gewissen Wölbung der Endflächen 3, 4 und damit der Endspiegel 5, 6. Die Ausbildung von Lasermodes von Microchip-Lasern unter Berücksichtigung der thermischen Linse ist bekannt.

Microchip-Laser werden im Betrieb meist mittels Heiz- und/oder Kühlelementen in einem vorgegebenen Betriebstemperaturbereich gehalten, beispielsweise mittels eines Peltier-Elements. Mindestens ein solches Heiz- und/oder Kühlelement, um den Microchip-Laser im Betrieb in einem vorgegebenen Temperaturbereich zu halten, ist beim erfindungsgemäßen Laser vorzugsweise vorgesehen, in Fig. 1 der Einfachheit halber aber nicht dargestellt.

Der aus dem Resonator 1 ausgekoppelte Laserstrahl 9 besitzt eine Laserstrahlachse 12. Im Resonator 1 entspricht die Achse des Laserstrahls (= des Lasermodes) ebenfalls der Laserstrahlachse 12.

Beim Laserkristall 2 handelt es sich im Ausführungsbeispiel um Nd3+:YVO4. Ein solcher Laserkristall ist doppelbrechend. YVO4 weist rechtwinkelig zueinander stehende a-Achsen 35, 36 und eine rechtwinkelig zu den a-Achsen 35, 36 stehende c-Achse 37 auf, vgl. Fig. 1 und 2. YVO4 ist doppelbrechend und hierbei optisch einachsig, wobei es als einzige kristalloptische Achse die c-Achse 37 besitzt.Bezüglich der c-Achse 37 ist YVO4 somit optisch isotrop. Es weist also für Polarisationsrichtungen des Lichts parallel zu den beiden a-Achsen 36, 36 den gleichen Brechungsindex auf.

Für einen Einfall eines unpolarisierten Lichtstrahls winkelig zur kristalloptischen Achse, im Ausführungsbeispiel also zur c-Achse 37, erfolgt eine Aufspaltung des Lichtstrahls in rechtwinkelig zueinander polarisierte Teilstrahlen, entsprechend dem ordentlichen und außerordentlichen Strahl. Bei einem Einfall eines unpolarisierten Lichtstrahls rechtwinkelig zur kristalloptischen Achse, im Ausführungsbeispiel also in der Ebene der a-Achsen 35, 36, beispielsweise parallel zu einer der a-Achsen 35, 36, wobei die Eintrittsfläche rechtwinkelig zur Einfallsrichtung des Lichtstrahls steht, kommt es zu keiner räumlichen Trennung des ordentlichen und außerordentlichen Strahls, diese fallen also zusammen, wobei sie aber parallel zur kristalloptischen Achse (für den außerordentlichen Strahl) und rechtwinkelig hierzu (für den ordentlichen Strahl) liegende Polarisationsrichtungen aufweisen, im Ausführungsbeispiel also parallel zur c-Achse 37 und parallel zur (anderen) a-Achse 35.

Die Achse des Laserstrahls 9 im Laserkristall 2 des Resonators 1 liegt rechtwinkelig zur kristalloptischen Achse, im Ausführungsbeispiel parallel zur a-Achse 36, wobei die Achse des Laserstrahls 9 im Laserkristall 2 auch in einer anderen Richtung rechtwinkelig zur kristalloptischen Achse, im Ausführungsbeispiel also in der von den a-Achsen 35, 36 aufgespannten Ebene, beispielsweise parallel zur anderen a-Achse 35, liegen könnte. Der Laserstrahl 9 kann also grundsätzlich eine Polarisation parallel zur kristalloptischen Achse, im Ausführungsbeispiel der c-Achse 37, oder rechtwinkelig hierzu, im Ausführungsbeispiel parallel zur a-Achse 35, einnehmen. Für welche dieser Polarisationen ein Laserstrahl (Lasermode) auftritt und aus dem Resonator 1 ausgekoppelt wird, wird weiter unten erläutert.

Damit sich ein Lasermode im Resonator ausbilden kann, muss die Modenbedingung erfüllt sein:

$$L = 1/2 * m * \text{Laserwellenlänge}/n$$

wobei L die Resonatorlänge bezeichnet, m ein ganzzahliger Wert ist und die Modenzahl und n den Brechungsindex bezeichnet. Da der Laserkristall doppelbrechend ist, sind die Brechungsindices no, ne für die dem ordentlichen und außerordentlichen Strahl entsprechenden Polarisationen unterschiedlich. Für die Laserwellenlänge wird die Verstärkungswellenlänge (entsprechend der Definition weiter vorne) eingesetzt. Ein ausreichend nahe bei dieser liegender Wert (innerhalb der Verstärkungsbandbreite von z.B. +/- 1 nm) würde auch noch zu einem Lasermode führen. Das Intensitätsmaximum wird aber beim Maximum der Verstärkung erreicht.

Für YVO4 ist der Brechungsindex ne für eine Polarisation parallel zur c-Achse 2,16 und der Brechungsindex no für eine Polarisation parallel zur a-Achse 1,96 (bezogen auf die Verstärkungswellenlänge von 1064 nm). Der Brechungsindexunterschied beträgt in diesem Fall also ca. 0,2, somit etwa 10%.

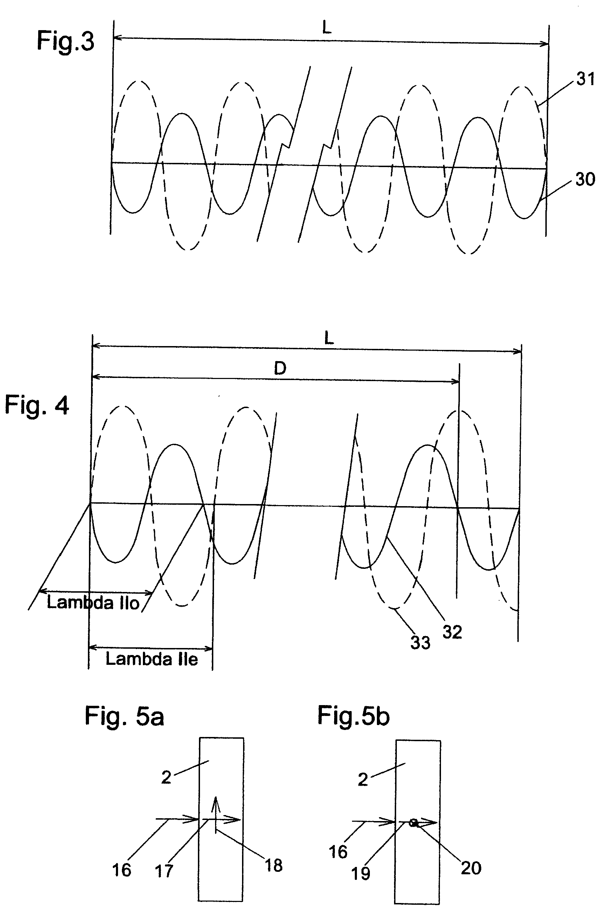

In Fig. 3 ist beispielhaft eine Länge L des Resonators dargestellt, bei welcher sowohl für stehende Wellen mit einer Polarisation parallel zur c-Achse 37 als auch parallel zur a-Achse 35 Resonanz auftritt. Die Verstärkungswellenlänge, z.b. 1064 nm für Nd3+:YVO4, ist im Resonator entsprechend dem Brechungsindex für die jeweilige Polarisation entsprechend gestaucht. Als durchgezogene Linie 30 ist in Fig. 3 das E-Feld für die Polarisation parallel zur c-Achse 37, also die Polarisation entsprechend dem außerordentlichen Strahl, und als strichlierte Linie 31 das E-Feld für die Polarisation parallel zur a-Achse 35, also für die Polarisation entsprechend dem ordentlichen Strahl, jeweils entlang der Laserstrahlachse 12, dargestellt. Aufgrund des höheren Brechungsindex ist die Wellenlänge für die Polarisation des außerordentlichen Strahls gegenüber derjenigen des ordentlichen Strahls gestaucht.

In der Situation entsprechend Fig. 3 ist somit für beide Polarisationen grundsätzlich die Ausbildung eines Modes möglich. Dies führt zu Instabilitäten. Welcher Mode sich tatsächlich ausbilden wird, hängt von kleinen Änderungen in den Parametern ab, beispielsweise der Temperatur.

In Fig. 3, ebenso wie in der zuvor angegebenen Modenbedingung, wurde der Einfachheit halber und zur Veranschaulichung angenommen, dass über die gesamte Länge des Resonators das Material des Laserkristalls vorliegt. Tatsächlich kann ein gewisser Teil der Länge L des Resonators von Schichten anderer Materialien gebildet sein, beispielsweise der Absorberschicht 7 oder Reflexionsschicht 8. Der in diesen Bereichen vorliegende Brechungsindex ist für die Modenbedingung in einer genaueren Betrachtungsweise zu berücksichtigen. Wenn diese zusätzlichen Schichten nicht doppelbrechend sind, sind die Wellenlängen für beide Polarisationsrichtungen in diesen Bereichen gleich.

Die Situation für einen in erfindungsgemäßer Weise ausgebildeten Laser geht aus Fig. 4 hervor. Die durchgezogene Linie 32 entspricht dem E-Feld für den Laserstrahl, der in Richtung des außerordentlichen Strahls, im Ausführungsbeispiel also in Richtung der c-Achse 37, polarisiert ist, entlang der Laserstrahlachse 12. Der Resonator ist für diesen Laserstrahl resonant (der Mode besitzt Knoten an den beiden Enden des Resonators). Mit anderen Worten ist für diesen Laserstrahl, der nach seiner Auskopplung die Laserwellenlänge entsprechend der Verstärkungswellenlänge aufweist, für Nd3+:YVO4 also ca. 1064 nm, die Modenbedingung erfüllt.

Für die Polarisation entsprechend dem ordentlichen Strahl, also im Ausführungsbeispiel parallel zur a-Achse 35, ist die Modenbedingung dagegen nicht erfüllt. Das E-Feld für einen gedachten Mode mit der Polarisation entsprechend dem ordentlichen Strahl würde einen Knoten an einem Ende des Resonators, aber einen Schwingungsbauch am anderen Ende besitzen. Die strichlierte Linie 32 in Fig. 4 veranschaulicht diese Situation. Ein solcher Mode wird somit unterdrückt und der ausgekoppelte Laserstrahl besitzt eine Polarisation entsprechend dem außerordentlichen Strahl.

In Fig. 4 ist auch die Ausdehnung des Laserkristalls 2 eingezeichnet, welche dieser in Richtung der Laserstrahlachse 12 aufweist, also seine Dicke D. Im Laserkristall 2 ist die Wellenlänge für die Polarisation entsprechend dem ordentlichen Strahl Lambda ∥ o und die Wellenlänge entsprechend dem außerordentlichen Strahl Lambda ∥ e, konkret für den Fall von Nd3+:YVO4:

$$\text{Lambda} \parallel o = \text{Lambda}/no = 1064\ nm/1{,}96 = 542{,}85\ nm$$

$$\text{Lambda} \parallel e = \text{Lambda}/ne = 1064\ nm/2{,}16 = 492{,}59\ nm\ (\text{"gestaucht"})$$

Lambda ist hierbei die Laserwellenlänge des ausgekoppelten Laserstrahls 9, die der Verstärkungswellenlänge entspricht.

Wenn im Bereich des Resonators, der außerhalb des Laserkristalls liegt, kein doppelbrechendes Material vorliegt, so ist in diesem Bereich Lambda ∥ o = Lambda ∥ e. Die Phasenrelation zwischen den E-Feldern der senkrecht zueinander polarisierten Moden bleibt hier also bestehen. Selbst wenn die Brechungsindices im Bereich außerhalb des Laserkristalls für die beiden Polarisationen unterschiedlich sein sollten, so kann der Effekt vernachlässigt werden, wenn die im außerhalb des Laserkristalls liegenden Bereich des Resonators hervorgerufene Phasenverschiebung ausreichend klein ist, insbesondere $<\pi/8$, vorzugsweise $<\pi/16$ ist. In Fig. 4 ist als Unterschied zwischen L und D der Einfachheit halber gerade eine halbe Wellenlänge eingezeichnet. Dies ist aber nur symbolisch so dargestellt. In der Praxis wird sich der Längenunterschied zwischen L und D hiervon im Allgemeinen unterscheiden.

Wenn man für den Laserkristall mit der Dicke D davon ausgeht, dass ein unpolarisierter Lichtstrahl, der die Laserwellenlänge aufweist, in Richtung der Laserstrahlachse 12 auf den Laserkristall 2 einfällt, so wird der Lichtstrahl im Laserkristall in einen ordentlichen und einen außerordentlichen Strahl aufgeteilt, da der Laserkristall 2 doppelbrechend ist. Wenn der Einfall rechtwinkelig zur kristalloptischen Achse, für Nd3+:YVO4 rechtwinkelig zur c-Achse, und auf eine Einfallfläche erfolgt, die rechtwinkelig zum einfallenden Lichtfall steht, so werden der außerordentliche und der ordentliche Strahl in diesem Fall nicht räumlich voneinander getrennt, sind aber rechtwinkelig zueinander polarisiert, und zwar ist der außerordentliche Strahl in Richtung der kristalloptischen Achse, für Nd3+:YVO4 also in Richtung der c-Achse, und der ordentliche Strahl rechtwinkelig hierzu, also für Nd3+:YVO4 in der von den a-Achsen aufgespannten Ebene, beispielsweise parallel zu einer der a-Achsen, polarisiert.

In Fig. 5a ist der auf den Laserkristall einfallende Lichtstrahl 16 zusammen mit dem ordentlichen Strahl 17 eingezeichnet, dessen Polarisation rechtwinkelig zur kristalloptischen Achse durch den Pfeil 18 angedeutet ist. In Fig. 5b ist der einfallende Lichtstrahl 16 zusammen mit dem außerordentlichen Strahl 19 dargestellt, dessen Polarisation parallel zur kristalloptischen Achse durch das Kreuz 20 angedeutet ist. Das E-Feld für den außerordentlichen Strahl entspricht der durchgezogenen Linie 32 über den Bereich des Laserkristalls 2 (also über die Ausdehnung entsprechend D) in Fig. 4 und das E-Feld des ordentlichen Strahls entspricht der strichlierten Linie 33 über die Ausdehnung entsprechend D in Fig. 4.

Die Dicke D des Laserkristalls in Richtung der Laserstrahlachse ist in Fig. 4 gerade so, dass die Phasenlage des E-Feldes des außerordentlichen Strahls 19 gegenüber der Phasenlage des ordentlichen Strahls 17 am Ende des Laserkristalls (also am Ende des Durchlaufs durch den Laserkristall) gegenüber dem Anfang des Laserkristalls (also dem Beginn des Durchlaufs durch den Laserkristall) um eine viertel Wellenlänge, d.h. um $\pi/2$, verzögert ist. Der Laserkristall 2 wirkt für den außerordentlichen Strahl also als Lambda/4-Plättchen gegenüber dem ordentlichen Strahl.

Für diese Dicke D des Laserkristalls wird somit, wenn der Lasermode der Polarisationsrichtung entsprechend dem außerordentlichen Strahl im Resonator in Resonanz ist, der Lasermode mit der hierzu rechtwinkeligen Polarisationsrichtung, also entsprechend dem ordentlichen Strahl, "bestmöglich" unterdrückt, d.h. ist weitestmöglich von der Erfüllung der Modenbedingung im Resonator entfernt.

Wie bereits erwähnt, wird hierbei davon ausgegangen, dass es außerhalb des Laserkristalls zu keinen weiteren Phasenverschiebungen zwischen den Moden kommt oder falls doch, diese ausreichend gering sind (vorzugsweise weniger als $\pi/8$, besonders bevorzugt weniger als $\pi/16$, betragen), so dass diese nicht ins Gewicht fallen.

Auch bei einer Abweichung von der genannten Ausbildung des Laserkristalls 2 als Lambda/4-Plättchen wird noch eine ausreichende Unterdrückung der nicht gewünschten Polarisation erreicht, so lange die Abweichung nicht zu groß ist. Die Größe der zulässigen Abweichung hängt auch von der Länge des Resonators und dem hiermit verbundenen "free spectral range" ab. Bei einem relativ kurzen Resonator kann aufgrund des größeren "free spectral range" eine größere Abweichung erlaubt werden, als bei einem längeren Resonator. So kann für eine Resonatorlänge von 50 $\mu$m oder weniger eine Phasenverschiebung zwischen dem ordentlichen und dem außerordentlichen Strahl bei einem einzelnen Durchlauf durch den Laserkristall zugelassen werden, die im Bereich von +/- $\pi/4$ liegt, vorzugsweise aber demgegenüber weniger von $\pi/2$ abweicht. Bei einer Länge des Resonators 1, die zumindest 50 $\mu$m aber weniger als 100 $\mu$m beträgt, liegt die Phasenverschiebung günstigerweise zumindest im Bereich von $\pi/2$ +/- $\pi/6$. Beträgt die Länge des Resonators 1 mindestens 100 $\mu$m aber weniger als 150 $\mu$m, so liegt die Phasenverschiebung günstigerweise zumindest im Bereich $\pi/2$ +/- $\pi/8$.

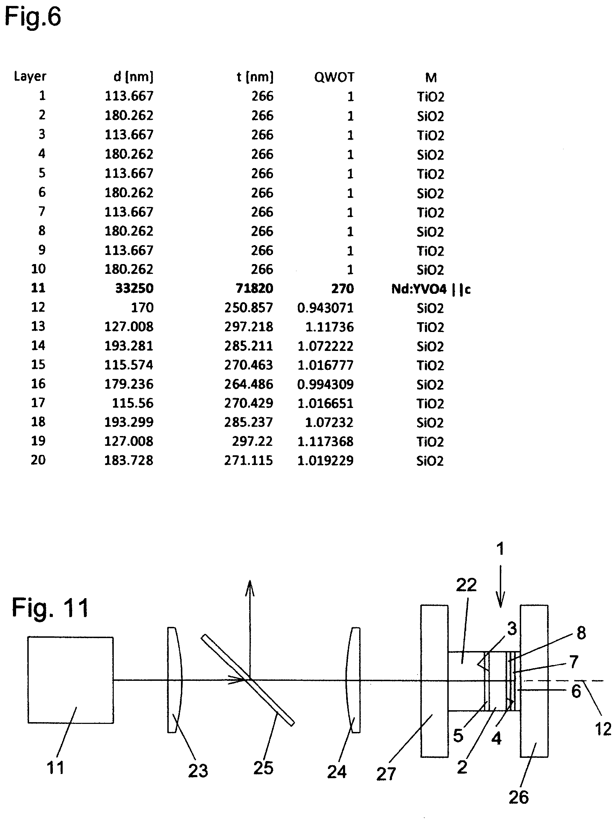

Im Weiteren werden zur Veranschaulichung Ergebnisse von numerischen Berechnungen der Resonanzlinien eines Resonators bei zwei unterschiedlichen Dicken des Laserkristalls 2 und entsprechenden unterschiedlichen Längen des Resonators 1 (der Resonator 1 ist ansonsten gleich ausgebildet) gezeigt. Die Berechnungen wurden für einen Resonator gemäß einer modifizierten Ausführungsform eines Microchip-Lasers durchgeführt, welche in Fig. 11 schematisch dargestellt ist:

Der Resonator 1 umfasst einen doppelbrechenden Laserkristall 2, beispielsweise Nd3+:YVO4. Auf die erste Endfläche 3 ist als erster Endspiegel 5 eine optische Beschichtung aufgebracht. Diese ist durchlässig für die Pumpstrahlung und teilreflektierend für den Laserstrahl. Die andere Endfläche 4 ist mit einer Reflexionsschicht 8 beschichtet, welche die Pumpstrahlung reflektiert, für den Laserstrahl durchlässig ist. An den mit der Reflexionsschicht 8 beschichteten Laserkristall 2 ist ein SESAM gebondet, der eine sättigbare Absorberschicht 7 und den zweiten Endspiegel 6 umfasst. Die Reflexionsschicht könnte vor dem Bonden auf den SESAM aufgebracht werden. Der SESAM ist hier auf einen Kühlkörper 26, beispielsweise aus Kupfer aufgebracht.

Die Auskopplung des Laserstrahls 9 erfolgt in diesem Ausführungsbeispiel durch den ersten Endspiegel 5. Der Laserkristall 2 mit der den ersten Endspiegel 5 bildenden optischen Beschichtung ist an einen undotierten YVO4-Kristall 22 gebondet, welcher außerhalb des Resonators liegt. Durch die stoffschlüssige Verbindung des Laserkristalls 2 mit dem YVO4-Kristall 22 wird die mechanische Bearbeitung des Laserkristalls 2 zur Ausbildung des Laserkristalls 2 mit einer kleinen Dicke D wesentlich vereinfacht. Auf den YVO4-Kristall 22 ist noch ein Fenster 27 (antireflexionsbeschichtet für die Pumpstrahlung und den Laserstrahl) aufgebracht. Als Strahlungsquelle für die Pumpstrahlung dient eine Laserdiode oder ein Laserdioden-Array. Die Übertragung kann mittels eines Lichtleiters 11 erfolgen, von dem in Fig. 11 schematisch ein Ende dargestellt ist. Ein solcher Lichtleiter kann auch entfallen. In Fig. 11 sind außerdem Linsen 23, 24 zur Fokussierung der Pumpstrahlung angedeutet. Für die Trennung des Laserstrahls von der Pumpstrahlung dient in diesem Ausführungsbeispiel ein dichroitischer Strahlteiler 25.

Für ein Schichtsystem entsprechend dem Resonator 1 von Fig. 11 wurden numerische Berechnungen durchgeführt. Zur Vereinfachung wurden aber die Reflexionsschicht 8 und die Absorberschicht 7 weggelassen. Die Länge L des Resonators 1 entspricht somit der Dicke D des Laserkristalls 2. Die Tabelle von Fig. 6 beschreibt das System, für welches die Berechnungen konkret durchgeführt wurden. In der Tabelle bezeichnet die erste Spalte die der jeweiligen Schicht zugeordnete Nummer. Die Spalte d bezeichnet die Dicke der jeweiligen Schicht in nm. Die Spalte t bezeichnet die "optische Dicke", dies ist die Dicke t mal dem Brechungsindex. Die Spalte QWOT bezeichnet die optische Dicke bezogen auf die Anzahl der Viertelwellenlängen. Die letzte Spalte M bezeichnet schließlich das Material der jeweiligen Schicht.

Die Schichten 1 bis 10 stellen einen Bragg-Spiegel dar, der von fünf Viertelwellenlängen-Paaren gebildet wird (bezogen auf die Wellenlänge 1064 nm). Die Reflektivität dieser zehn Schichten bei 1064 nm liegt bei ca. 98%, also nahe bei einem Hochreflektor. Eine Erhöhung der Anzahl der Schichten des Bragg-Spiegels könnte die Reflektivität noch weiter erhöhen.

Schicht 11 stellt den Laserkristall dar, im vorliegenden Fall Nd3+:YVO4. Zunächst wurde eine Dicke von 33,25 $\mu$m betrachtet. Für den Laserkristall 2 wurde in der Tabelle von Fig. 6 der Brechungsindex ne für die Polarisation in Richtung des außerordentlichen Strahls eingesetzt (symbolisiert durch Nd3+:YVO4 ∥ c, also für den Fall von Nd3+:YVO4 2,16. Damit erfolgt die Berechnung der Reflektivität des Resonators für einen Lichtstrahl mit einer Polarisation entsprechend dem außerordentlichen Strahl. Für die Berechnung der Reflektivität für einen Strahl mit einer Polarisation entsprechend dem ordentlichen Strahl wird als Brechungsindex des Laserkristalls no, also für den Fall von Nd3+:YVO4 1,96, herangezogen.

Die Schichten 12 bis 20 stellen den ersten Endspiegel 5 dar, der im Ausführungsbeispiel bei der Wellenlänge 808 nm der Pumpstrahlung nahezu vollständig transmittierend ist und bei der Laserwellenlänge von im Ausführungsbeispiel 1064 nm 95% Reflektivität aufweist. Beim Ausführungsbeispiel entsprechend Fig. 11 würde die Schicht 20 auf YVO4 als Trägersubstrat angeordnet sein.

Die hier verwendeten Schichtmaterialien sind TiO2 und SiO2, wobei auch andere in der Beschichtungstechnik üblichen Materialien möglich sind, z.B. Ta2O5.

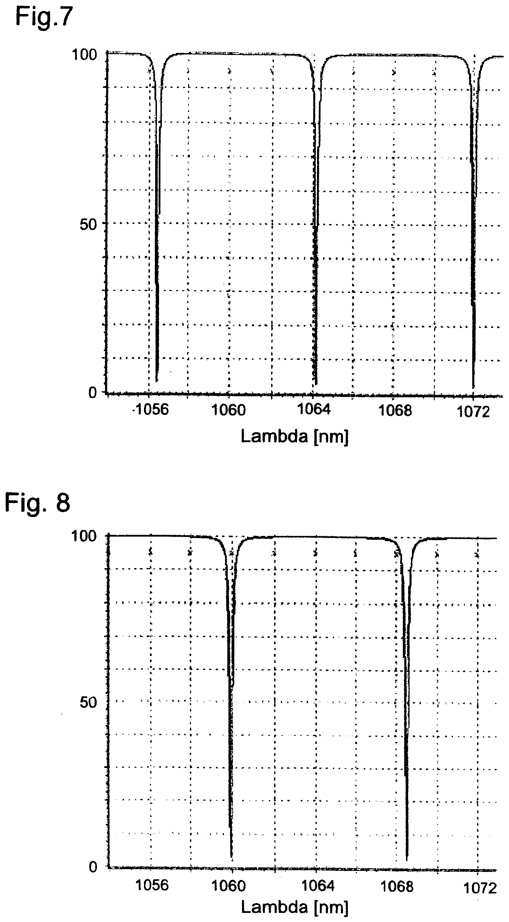

Das Ergebnis der Berechnung der Reflektivität in % in Abhängigkeit von der Wellenlänge für die Polarisation parallel zum ordentlichen Strahl und parallel zum außerordentlichen Strahl sind in den Fig. 7 und 8 dargestellt. Aus Fig. 7 ist ersichtlich, dass es zu einem Einbruch der Reflektivität des Systems bei einer Wellenlänge von ca. 1064 nm, also der Verstärkungswellenlänge des Materials des Laserkristalls kommt. Dies entspricht einer Resonanz im Resonator für einen mit dieser Wellenlänge ausgekoppelten Laserstrahl. Die benachbarten Resonanzen treten bei Wellenlängen von ca. 1056 nm und 1072 nm auf. Der "free spectral range" beträgt also ca. 8 nm.

Fig. 8 zeigt die Resonanzen für die Polarisation in Richtung des außerordentlichen Strahls. Die der Verstärkungswellenlänge von 1064 nm nächstgelegenen Resonanzen liegen bei ca. 1060 nm und 1068 nm, weisen also den maximal möglichen Abstand von 1064 nm auf.

Bei der Dicke D des Laserkristalls 2, die beim betrachteten Schichtsystem der Länge L des Resonators 1 entspricht, von 33,25 $\mu$m ergibt sich für die Polarisation in Richtung des außerordentlichen Strahls L/(Lambda/ne) = 67,5, d.h. die Wellenlänge passt 67,5-mal in den Laserkristall (entsprechend der Modenzahl von m=135). Für die Polarisation in Richtung des ordentlichen Strahls ergibt sich L/(Lambda/no) = 61,25, d.h. die Modenzahl m würde 122,5 betragen, was keine ganzzahlige Modenzahl ist, da es keinen gültigen Mode für die Polarisation in Richtung des ordentlichen Strahls bei der Verstärkerwellenlänge gibt, wie dies erwünscht ist. Für eine Dicke D des Laserkristalls von 33,25 $\mu$m ergibt sich also bei einem Durchlauf durch den Laserkristall 2 eine Phasenverschiebung zwischen dem ordentlichen Strahl und dem außerordentlichen Strahl von $\pi$/2.

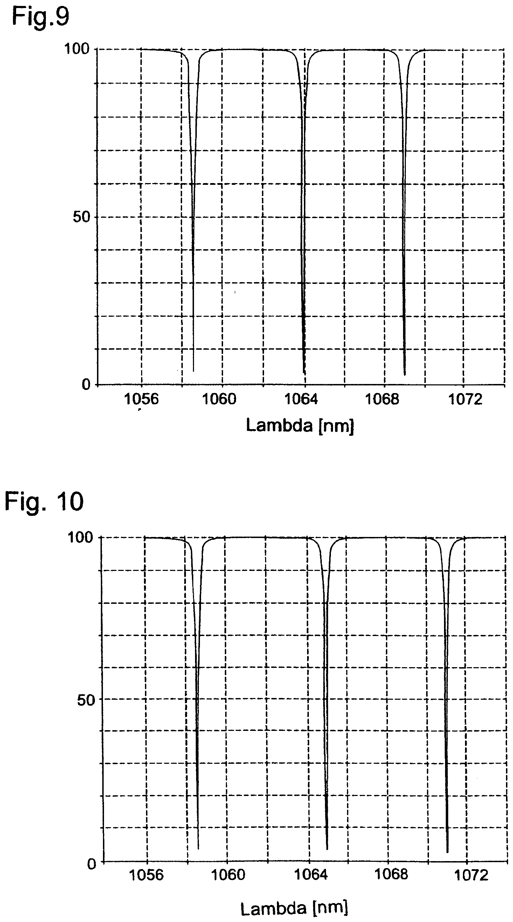

Die Fig. 9 und 10 zeigen Diagramme entsprechend Fig. 7 und 8 für ein Vergleichsbeispiel, bei welchem der Laserkristall eine Dicke von 49,998 $\mu$m aufweist. Für die Polarisation in Richtung des außerordentlichen Strahls kommt es wiederum wie gewünscht zur Resonanz bei 1064 nm. Für die Polarisation in Richtung des ordentlichen Strahls liegt die hierzu nächste Resonanz in diesem Fall bei ca. 1065 nm. Der Abstand ist bei dieser Dicke D des Laserkristalls somit zu gering, als dass sich ein stabiler Betrieb des Lasers mit der gewünschten Polarisation parallel zum außerordentlichen Strahl einstellt.

Zur Bestimmung einer geeigneten Dicke des Laserkristalls für einen stabilen Betrieb des Lasers bei einer der Polarisationsrichtungen muss somit einerseits die Bedingung erfüllt werden, dass der Resonator für die gewünschte Polarisationsrichtung entsprechend dem außerordentlichen oder ordentlichen Strahl eine Resonanz bei der Laserwellenlänge aufweist, die der Verstärkungswellenlänge entspricht. Außerdem muss die Bedingung erfüllt werden, dass die Phasenverschiebung für die Polarisationsrichtungen entsprechend dem außerordentlichen und ordentlichen Strahl im zuvor beschriebenen Bereich liegt.

Im konkret beschriebenen Beispiel wurde die Polarisation entsprechend dem außerordentlichen Strahl ausgewählt und die Polarisation rechtwinkelig hierzu unterdrückt. Für Nd3+:YVO4 ist dies vorteilhaft, da für die Polarisationsrichtung entsprechend dem außerordentlichen Strahl eine höhere Verstärkung als für die rechtwinkelig hierzu stehende Polarisationsrichtung vorliegt. In analoger Weise kann aber eine Polarisationsrichtung entsprechend dem ordentlichen Strahl ausgewählt werden und die Polarisationsrichtung entsprechend dem außerordentlichen Strahl unterdrückt werden.

Unterschiedliche Modifikationen der gezeigten Ausführungsbeispiele sind denkbar und möglich, ohne den Bereich der Erfindung zu verlassen, beispielsweise hinsichtlich des Schichtaufbaus des Resonators und hinsichtlich des doppelbrechenden Materials des Laserkristalls. In vorteilhaften Ausführungsformen der Erfindung weist das doppelbrechende Material des Laserkristalls nur eine kristalloptische Achse auf (= optisch einachsiger Kristall), könnte aber auch mehr als eine kristalloptische Achse aufweisen, wobei die Achse des Laserstrahls im Laserkristall und die Laserstrahlachse des ausgekoppelten Laserstrahls rechtwinklig zu einer der kristalloptischen Achsen liegen könnten.

| Legende zu den Hinweisziffern: | | | |
|---|---|---|---|
| 1 | Resonator | 19 | außerordentlicher Strahl |
| 2 | Laserkristall | 20 | Kreuz |
| 3 | Endfläche | 21 | Trägersubstrat |
| 4 | Endfläche | 22 | YVO4-Kristall |
| 5 | erster Endspiegel | 23 | Linse |
| 6 | zweiter Endspiegel | 24 | Linse |
| 7 | Absorberschicht | 25 | Strahlteiler |
| 8 | Reflexionsschicht | 26 | Kühlkörper |
| 9 | Laserstrahl | 27 | Fenster |

(fortgesetzt)

| 10 | Pumpstrahlung | 30 | Linie |
|----|----|----|----|
| 11 | Lichtleiter | 31 | Linie |
| 12 | Laserstrahlachse | 32 | Linie |
| 16 | Lichtstrahl | 35 | a-Achse |
| 17 | ordentlicher Strahl | 36 | a-Achse |
| 18 | Pfeil | 37 | c-Achse |

**Patentansprüche**

1. Microchip-Laser mit einem monolithischen Resonator (1), der einen doppelbrechenden Laserkristall (2) aufweist, wobei ein aus dem Resonator (1) ausgekoppelter Laserstrahl (9), der eine Laserwellenlänge aufweist, entlang einer Laserstrahlachse (12) aus dem Resonator (1) austritt und die auf die Richtung der Laserstrahlachse (12) bezogene Länge (L) des Resonators (1) <=50 μm ist, **dadurch gekennzeichnet, dass** der Laserkristall (2) eine derartige auf die Richtung der Laserstrahlachse (12) bezogene Dicke (D) aufweist, dass bei einem in Richtung der Laserstrahlachse (12) erfolgenden Einfall eines die Laserwellenlänge aufweisenden Lichtstrahls (16) auf den Laserkristall (2) zwischen dem ordentlichen und dem außerordentlichen Strahl (17, 19), in welche der Lichtstrahl (16) im Laserkristall (2) aufgeteilt wird, bei einem einzelnen Durchlauf durch den Laserkristall (2) eine Phasenverschiebung auftritt, die im Bereich von $\pi/2$ +/- $\pi/4$ liegt.

2. Microchip-Laser nach Anspruch 1, **dadurch gekennzeichnet, dass** die Phasenverschiebung im Bereich von $\pi/2$ +/- $\pi/8$ liegt.

3. Microchip-Laser nach einem der Ansprüche 1 oder 2, **dadurch gekennzeichnet, dass** der Microchip-Laser passiv gütegeschaltet ist, wobei die Pulslänge vorzugsweise weniger als 100 ps, besonders bevorzugt weniger als 50 ps, nochmals besonders bevorzugt weniger als 20 ps beträgt.

4. Microchip-Laser nach einem der Ansprüche 1 bis 3, **dadurch gekennzeichnet, dass** den Resonator (1) beidseitig begrenzende Endspiegel (5, 6) zumindest ohne eine auf den Resonator einfallende Pumpstrahlung (10) eben sind und parallel zueinander und rechtwinkelig zur Laserstrahlachse (12) liegen.

5. Microchip-Laser nach einem der Ansprüche 1 bis 4, **dadurch gekennzeichnet, dass** die Laserstrahlachse (12) rechtwinkelig zu einer kristalloptischen Achse des Laserkristalls (2) steht, wobei der Laserkristall vorzugsweise nur eine kristalloptische Achse aufweist, bezüglich welcher der Laserkristall (2) optisch isotrop ist.

6. Microchip-Laser nach einem der Ansprüche 1 bis 5, **dadurch gekennzeichnet, dass** der Laserkristall (2) ein Vanadat, vorzugsweise Nd3+:YVO4 ist.

7. Microchip-Laser nach einem der Ansprüche 1 bis 6, **dadurch gekennzeichnet, dass** die auf die Richtung der Laserstrahlachse (12) bezogene Länge (L) des Resonators weniger als 30%, vorzgusweise weniger als 15%, größer als die auf die Richtung der Laserstrahlachse (12) bezogene Dicke (D) des Laserkristalls (2) ist.

8. Microchip-Laser nach einem der Ansprüche 1 bis 7, **dadurch gekennzeichnet, dass** es zwischen einem die Laserwellenlänge aufweisenden, in Richtung des ordentlichen Strahls (17) polarisierten Lichtstrahl und einem die Laserwellenlänge aufweisenden, in Richtung des außerordentlichen Strahls (19) polarisierten Lichtstrahl bei einem einzelnen Durchgang durch zusätzlich zum Laserkristall (2) vorhandene Schichten im Resonator (1) zu einer Phasenverschiebung von weniger als $\pi/8$, vorzugsweise weniger als $\pi/16$ kommt.

9. Verfahren zur Ausbildung eines Microchip-Lasers mit einem monolithischen Resonator (1), der einen doppelbrechenden Laserkristall (2) aufweist, wobei ein aus dem Resonator (1) ausgekoppelter Laserstrahl (9), der eine Laserwellenlänge aufweist, entlang einer Laserstrahlachse (12) aus dem Resonator (1) austritt und die auf die Richtung der Laserstrahlachse (12) bezogene Länge (L) des Resonators (1) <=50 μm μm ist, wobei die Bedingung erfüllt wird, dass der Resonator (1) für eine gewünschte Polarisationsrichtung entsprechend einem außerordentlichen oder ordentlichen Strahl im Laserkristall eine Resonanz bei der Laserwellenlänge aufweist, bei der ein Maximum der Verstärkung des Laserkristalls vorliegt, **dadurch gekennzeichnet, dass** für einen in Richtung der Laserstrahlachse (12) erfolgenden Einfall eines die Laserwellenlänge aufweisenden Lichtstrahls auf den Laserkristall (2) eine Phasenverschiebung zwischen dem ordentlichen und dem außerordentlichen Strahl (17, 19), in welche der Lichtstrahl im Laserkristall aufgeteilt wird, für einen einzelnen Durchlauf durch den Laserkristall (2) berechnet wird und die auf die Laserstrahlachse (12) bezogene Dicke (D) des Laserkristalls (2) so gewählt wird, dass die Phasenver-schiebung im Bereich von $\pi/2$ +/- $\pi/4$, vorzugsweise $\pi/2$ +/- $\pi/8$ liegt.

## Claims

1. Microchip laser comprising a monolithic resonator (1), which comprises a birefringent laser crystal (2), a laser beam (9) coupled out of the resonator (1) and having a laser wavelength emanating from the resonator (1) along a laser beam axis (12) and the length (L) of the resonator (1) in the direction of the laser beam axis (12) being <=50 $\mu$m, **characterised in that** the laser crystal (2) has such a thickness (D) in the direction of the laser beam axis (12) that, when a light beam (16) having the laser wavelength is incident on the laser crystal (2) in the direction of the laser beam axis (12), a phase shift in the range of n/2 +/- n/4 occurs between the ordinary and the extraordinary ray (17, 19), into which the light beam (16) splits in the laser crystal (2), during a single passage through the laser crystal (2).

2. Microchip laser according to claim 1, **characterised in that** the phase shift is in the range of n/2 +/- n/8.

3. Microchip laser according to any of claims 1 or 2, **characterised in that** the microchip laser is passively Q-switched, the pulse duration preferably being less than 100 ps, particularly preferably less than 50 ps, even more particularly preferably less than 20 ps.

4. Microchip laser according to any of claims 1 to 3, **characterised in that** end mirrors (5, 6) delimiting the resonator (1) on both sides are flat at least without pump radiation incident on the resonator (10) and lie in parallel with one another and at a right angle to the laser beam axis (12).

5. Microchip laser according to any of claims 1 to 4, **characterised in that** the laser beam axis (12) is at a right angle to a crystal optical axis of the laser crystal (2), the laser crystal preferably having only one crystal optical axis with respect to which the laser crystal (2) is optically isotropic.

6. Microchip laser according to any of claims 1 to 5, **characterised in that** the laser crystal (2) is a vanadate, preferably Nd3+:YV04.

7. Microchip laser according to any of claims 1 to 6, **characterised in that** the length (L) of the resonator in the direction of the laser beam axis (12) is less than 30%, preferably less than 15%, greater than the thickness (D) of the laser crystal (2) in the direction of the laser beam axis (12).

8. Microchip laser according to any of claims 1 to 7, **characterised in that** a phase shift of less than n/8, preferably less than n/16, occurs between a light beam that has the laser wavelength and is polarised in the direction of the ordinary ray (17) and a light beam that has the laser wavelength and is polarised in the direction of the extraordinary ray (19) during a single passage through layers in the resonator (1) that are present in addition to the laser crystal (2).

9. Method for designing a microchip laser comprising a monolithic resonator (1), which comprises a birefringent laser crystal (2), a laser beam (9) coupled out of the resonator (1) and having a laser wavelength emanating from the resonator (1) along a laser beam axis (12) and the length (L) of the resonator (1) in the direction of the laser beam axis (12) being <=50 $\mu$m, the condition that the resonator (1) has a resonance at the laser wavelength at which there is a maximum of the amplification of the laser crystal for a desired polarisation direction in accordance with an extraordinary or ordinary ray being fulfilled, **characterised in that** a phase shift between the ordinary and the extraordinary ray (17, 19), into which the light beam splits in the laser crystal, is calculated for incidence of a light beam having the laser wavelength on the laser crystal (2) in the direction of the laser beam axis (12) for a single passage through the laser crystal (2) and the thickness (D) of the laser crystal (2) in relation to the laser beam axis (12) is selected such that the phase shift is in the range of n/2 +/- n/4, preferably n/2 +/- n/8.

## Revendications

1. Laser à micropuce avec un résonateur monolithique (1) qui est muni d'un cristal laser à double réfraction (2), où un faisceau laser (9) déclenché du résonateur (1) et présentant une longueur d'onde laser sort du résonateur (1) le long d'un axe du faisceau laser (12), et la longueur (L) du résonateur (1) par rapport à la direction de l'axe du faisceau laser (12) est <=50 μm, **caractérisé en ce que** le cristal laser (2) a une épaisseur (D) par rapport à la direction de l'axe du faisceau laser (12) telle que lors de l'incidence sur le cristal laser (2) dans la direction de l'axe du faisceau laser (12) d'un faisceau lumineux (16) ayant la longueur d'onde du laser, il se produit, en un seul passage à travers le cristal laser (2), un déphasage entre le rayon ordinaire et le rayon extraordinaire (17, 19) en lesquels le faisceau lumineux (16) est divisé, déphasage qui se situe dans la plage $\pi/2$ +/- $\pi/4$.

2. Laser à micropuce selon la revendication 1, **caractérisé en ce que** le déphasage se situe dans la plage $\pi/2$ +/- $\pi/8$.

3. Laser à micropuce selon l'une des revendications 1 ou 2, **caractérisé en ce que** le laser à micropuce est à commutation Q passive, la longueur d'impulsion étant de façon avantageuse inférieure à 100 ps, de façon préférée inférieure à 50 ps, et de façon privilégiée inférieure à 20 ps.

4. Laser à micropuce selon l'une des revendications 1 à 3, **caractérisé en ce que** des miroirs d'extrémité (5, 6) délimitant le résonateur (1) des deux côtés sont plans au moins en l'absence d'un rayonnement de pompage (10) incident sur le résonateur, et sont parallèles entre eux et perpendiculaires à l'axe du faisceau laser (12).

5. Laser à micropuce selon l'une des revendications 1 à 4, **caractérisé en ce que** l'axe du faisceau laser (12) est perpendiculaire à un axe optique de cristal du cristal laser (2), le cristal laser ne présentant de préférence qu'un seul axe optique de cristal par rapport auquel le cristal laser (2) est optiquement isotrope.

6. Laser à micropuce selon l'une des revendications 1 à 5, **caractérisé en ce que** le cristal laser (2) est un vanadate, de préférence du Nd3+:YVO4.

7. Laser à micropuce selon l'une des revendications 1 à 6, **caractérisé en ce que** la longueur (L) du résonateur par rapport à la direction de l'axe du faisceau laser (12) est moins de 30 %, de préférence moins de 15 %, plus grand que l'épaisseur (D) du cristal laser (2) par rapport à la direction de l'axe du faisceau laser (12).

8. Laser à micropuce selon l'une des revendications 1 à 7, **caractérisé en ce qu'**un déphasage inférieur à $\pi/8$, de préférence inférieur à $\pi/16$, se produit, en un seul passage à travers des couches présentes dans le résonateur (1) en plus du cristal laser (2), entre un faisceau lumineux ayant la longueur d'onde du laser et polarisé dans la direction du rayon ordinaire (17) et un faisceau lumineux ayant la longueur d'onde du laser et polarisé dans la direction du rayon extraordinaire (19).

9. Procédé de formation d'un laser à micropuce avec un résonateur monolithique (1) qui est muni d'un cristal laser à double réfraction (2), où un faisceau laser (9) déclenché du résonateur (1) et présentant une longueur d'onde laser, sort du résonateur (1) le long d'un axe du faisceau laser (12), et la longueur (L) du résonateur (1) par rapport à la direction de l'axe du faisceau laser (12) est <=50 μm, les conditions étant satisfaites pour que le résonateur (1) présente une résonance dans le cristal laser à la longueur d'onde du laser pour une direction de polarisation souhaitée correspondant à un rayon extraordinaire ou ordinaire, résonance à laquelle le maximum d'amplification est atteint, **caractérisé en ce que** pour une incidence sur le cristal laser (2) dans la direction de l'axe du faisceau laser (12) d'un faisceau lumineux ayant la longueur d'onde du laser, on calcule un déphasage, pour un seul passage à travers le cristal laser (2), entre le rayon ordinaire et le rayon extraordinaire (17, 19) en lesquels le faisceau lumineux est divisé dans le cristal laser, et l'épaisseur (D) du cristal laser (2) par rapport à l'axe du faisceau laser (12) est choisie de telle sorte que le déphasage se situe dans la plage de $\pi/2$ +/$\pi/4$, de préférence $\pi/2$ +/- $\pi/8$.

Fig.1

Fig. 2

Fig.3

L

31

30

Fig. 4

L

D

Lambda IIo

Lambda IIe

33 32

Fig. 5a

2

16 17 18

Fig.5b

2

16 19 20

## Fig.6

| Layer | d [nm] | t [nm] | QWOT | M |
|---|---|---|---|---|
| 1 | 113.667 | 266 | 1 | TiO2 |
| 2 | 180.262 | 266 | 1 | SiO2 |
| 3 | 113.667 | 266 | 1 | TiO2 |
| 4 | 180.262 | 266 | 1 | SiO2 |
| 5 | 113.667 | 266 | 1 | TiO2 |
| 6 | 180.262 | 266 | 1 | SiO2 |
| 7 | 113.667 | 266 | 1 | TiO2 |
| 8 | 180.262 | 266 | 1 | SiO2 |
| 9 | 113.667 | 266 | 1 | TiO2 |
| 10 | 180.262 | 266 | 1 | SiO2 |
| **11** | **33250** | **71820** | **270** | **Nd:YVO4 ‖c** |
| 12 | 170 | 250.857 | 0.943071 | SiO2 |
| 13 | 127.008 | 297.218 | 1.11736 | TiO2 |
| 14 | 193.281 | 285.211 | 1.072222 | SiO2 |
| 15 | 115.574 | 270.463 | 1.016777 | TiO2 |
| 16 | 179.236 | 264.486 | 0.994309 | SiO2 |
| 17 | 115.56 | 270.429 | 1.016651 | TiO2 |
| 18 | 193.299 | 285.237 | 1.07232 | SiO2 |
| 19 | 127.008 | 297.22 | 1.117368 | TiO2 |
| 20 | 183.728 | 271.115 | 1.019229 | SiO2 |

Fig. 11

## Fig.7

Lambda [nm]

## Fig. 8

Lambda [nm]

# Fig.9

Lambda [nm]

# Fig. 10

Lambda [nm]

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2011147799 A1

- DE 102012005492 A1

**In der Beschreibung aufgeführte Nicht-Patentliteratur**

- **MEHNER E.** Sub-20-ps pulses from a passively Q-switched microchip laser at 1 MHz repetition rate. *OPTICS LETTERS,* 15. Mai 2014, vol. 39 (10), 2940-2943

- **BERNARD B et al.** 26 ps pulses from a passively Q-switched microchip laser. *Proc of SPIE,* 04. Marz 2014, vol. 8960, 89601D-1, 89601D-7